# EUROPEAN PATENT SPECIFICATION

(11) **EP 1 833 099 B1**
(45) Date of publication and mention of the grant of the patent: **03.08.2016**
(21) Application number: 07100825.4
(22) Date of filing: 19.01.2007
(51) Int. Cl.: H01L 31/18, H01L 31/0224

(54) **Solar cell production using non-contact patterning and direct-write metallization**
Solarzellenherstellung unter Verwendung von kontaktloser Musterbildung und Metallisierung mit Direktbeschriftung
Fabrication de cellules solaires utilisant un placement de motif sans contact et métallisation par écriture directe

(30) Priority: 20.01.2006 US 336714
(43) Date of publication of application: 12.09.2007
(73) Proprietor: Palo Alto Research Center Incorporated, Palo Alto, California 94304 (US)
(72) Inventor: Fork, David K., Los Altos, CA 94024 (US); Maeda, Patrick Y., Mountain View, CA 94040 (US); Arias, Ana C., San Carlos, CA 94070 (US); Curry, Douglas N., Palo Alto, CA 94306 (US)
(74) Representative: Grünecker Patent- und Rechtsanwälte PartG mbB

(56) References cited:
- WO-A-92/15845
- US-A1- 2004 200 520
- US-B1- 6 310 281
- US-E1- R E37 512
- SZLUFCIK J ET AL: "Low-Cost Industrial Technologies of Crystalline Silicon Solar Cells" PROCEEDINGS OF THE IEEE, IEEE. NEW YORK, US, vol. 85, no. 5, 1 May 1997 (1997-05-01), pages 711-730, XP011043842 ISSN: 0018-9219
- RUTHE D ET AL: "Etching of CuInSe2 thin films-comparison of femtosecond and picosecond laser ablation" APPLIED SURFACE SCIENCE, ELSEVIER, AMSTERDAM, NL, vol. 247, no. 1-4, 15 July 2005 (2005-07-15), pages 447-452, XP025284205 ISSN: 0169-4332 [retrieved on 2005-07-15]

## Description

### FIELD OF THE INVENTION

This invention relates to the conversion of light irradiation to electrical energy, more particularly, to methods and tools for producing photovoltaic devices (solar cells) that convert solar energy to electrical energy.

### BACKGROUND OF THE INVENTION

Solar cells are typically photovoltaic devices that convert sunlight directly into electricity. Solar cells typically include a semiconductor (e.g., silicon) that absorbs light irradiation (e.g., sunlight) in a way that creates free electrons, which in turn are caused to flow in the presence of a built-in field to create direct current (DC) power. The DC power generated by several PV cells may be collected on a grid placed on the cell. Current from multiple PV cells is then combined by series and parallel combinations into higher currents and voltages. The DC power thus collected may then be sent over wires, often many dozens or even hundreds of wires.

The state of the art for metallizing silicon solar cells for terrestrial deployment is screen printing. Screen printing has been used for decades, but as cell manufacturers look to improve cell efficiency and lower cost by going to thinner wafers, the screen printing process is becoming a limitation. The screen printers run at a rate of about 1800 wafers per hour and the screens last about 5000 wafers. The failure mode often involves screen and wafer breakage. This means that the tools go down every couple of hours, and require frequent operator intervention. Moreover, the printed features are limited to about 100 microns, and the material set is limited largely to silver and aluminum metallizations.

The desired but largely unavailable features in a wafer-processing tool for making solar cells are as follows: (a) never breaks a wafer - e.g. non contact; (b) one second processing time (i.e., 3600 wafers/hour); (c) large process window; and (d) 24/7 operation other than scheduled maintenance less than one time per week. The desired but largely unavailable features in a low-cost metal semiconductor contact for solar cells are as follows: (a) Minimal contact area - to avoid surface recombination; (b) Shallow contact depth - to avoid shunting or otherwise damaging the cell's *pn* junction; (c) Low contact resistance to lightly doped silicon; and (d) High aspect metal features (for front contacts to avoid grid shading while providing low resistance to current flow).

Given the above set of desired features, the tool set for the next generation solar cell processing line is expected to look very different from screen printing. Since screen printing is an inherently low resolution contact method, it is unlikely to satisfy all of the criteria listed above. Solar cell fabrication is an inherently simple process with tremendous cost constraints. All of the printing that is done on most solar cells is directed at contacting and metallizing the emitter and base portions of the cell. The metallization process can be described in three steps, (1) opening a contact through the surface passivation, (2) making an electrical contact to the underlying silicon along with a robust mechanical contact to the solar cell and (3) providing a conducting path away from the contact.

Currently, the silver pastes used by the solar industry consist of a mixture of silver particles and a glass frit in an organic vehicle. Upon heating, the organic vehicle decomposes and the glass frit softens and then dissolves the surface passivation layer creating a pathway for silicon to reach the silver. The surface passivation, which may also serve as an anti-reflection coating, is an essential part of the cell that needs to cover the cell in all but the electrical contact areas. The glass frit approach to opening contacts has the advantage that no separate process step is needed to open the passivation. The paste mixture is screened onto the wafer, and when the wafer is fired, a multitude of random point contacts are made under the silver pattern. Moreover, the upper portions of the paste densify into a metal thick film that carries current from the cell. These films form the gridlines on the wafer's front-side, and the base contact on the wafer's backside. The silver is also a surface to which the tabs that connect to adjacent cells can be soldered. A disadvantage of the frit paste approach is that the emitter (sun-exposed surface) must be heavily doped otherwise the silver cannot make good electrical contact to the silicon. The heavy doping kills the minority carrier lifetime in the top portion of the cell. This limits the blue response of the cell as well as its overall efficiency.

In the conventional screen printing approach to metallizing solar cells, a squeegee presses a paste through a mesh with an emulsion pattern that is held over the wafer. Feature placement accuracy is limited by factors such as screen warpage and stretching. The feature size is limited by the feature sizes of the screen and the rheology of the paste. Feature sizes below 100 microns are difficult to achieve, and as wafers become larger, accurate feature placement and registration becomes more difficult. Because it is difficult to precisely register one screen printed pattern with another screen printed pattern, most solar cell processes avoid registering multiple process steps through methods like the one described above in which contacts are both opened and metallized as the glass frit in the silver paste dissolves the nitride passivation. This method has numerous drawbacks however. Already mentioned is the heavy doping required for the emitter. Another problem is a narrow process window. The thermal cycle that fires the gridline must also burn through the silicon nitride to provide electrical contact between the silicon and the silver without allowing the silver to shunt or otherwise damage the junction. This severely limits the process time and the temperature window to a temperature band on the order of 10 degrees C about a set point of 850C and a process time of on the order of 30 seconds. However, if one can form a contact opening and register metallization of the desired type, a lower contact resistance can be achieved with a wider process margin.

The most common photovoltaic device cell design in production today is the front surface contact cell, which includes a set of gridlines on the front surface of the substrate that make contact with the underlying cell's emitter. Ever since the first silicon solar cell was fabricated over 50 years ago, it has been a popular sport to estimate the highest achievable conversion efficiency of such a cell. At one terrestrial sun, this so-called limit efficiency is now firmly established at about 29% (see Richard M. Swanson, "APPROACHING THE 29% LIMIT EFFICIENCY OF SILICON SOLAR CELLS" 31s IEEE Photovoltaic Specialists Conference 2005). Laboratory cells have reached 25%. Only recently have commercial cells achieved a level of 20% efficiency. One successful approach to making photovoltaic devices with greater than 20% efficiency has been the development of backside contact cells. Backside contact cells utilize localized contacts that are distributed throughout p and n regions formed on the backside surface of the device wafer (i.e., the side facing away from the sun) to collect current from the cell. Small contact openings finely distributed on the wafer not only limit recombination but also reduce resistive losses by serving to limit the distance carriers must travel in the relatively less conductive semiconductor in order to reach the better conducting metal lines.

One route to further improvement is to reduce the effect of carrier recombination at the metal semiconductor interface in the localized contacts. This can be achieved by limiting the metal-semiconductor contact area to only that which is needed to extract current. Unfortunately, the contact sizes that are readily produced by low-cost manufacturing methods, such a screen printing, are larger than needed. Screen printing is capable of producing features that are on the order of 100 microns in size. However, features on the order of 10 microns or smaller can suffice for extracting current. For a given density of holes, such size reduction will reduce the total metal-semiconductor interface area, and its associated carrier recombination, by a factor of 100.

The continual drive to lower the manufacturing cost of solar power makes it preferable to eliminate as many processing steps as possible from the cell fabrication sequence. As described in US Published Application No. US20040200520 A1 by SunPower Corporation, typically, the current openings are formed by first depositing a resist mask onto the wafer, dipping the wafer into an etchant, such a hydrofluoric acid to etch through the oxide passivation on the wafer, rinsing the wafer, drying the wafer, stripping off the resist mask, rinsing the wafer and drying the wafer.

What is needed is a method and processing system for producing photovoltaic devices (solar cells) that overcomes the deficiencies of the conventional approach described above by both reducing the manufacturing costs and complexity, and improving the operating efficiency of the resulting photovoltaic devices.

US 2004/0200520 A1 describes metal contact structure for solar cell and method of manufacture. In a solar cell having p doped regions and n doped regions alternately formed in a surface of a semiconductor wafer in offset levels through use of masking and etching techniques, metal contacts are made to the p regions and n regions by first forming a base layer contacting the p doped regions and n doped regions which functions as an antireflection layer, and then forming a barrier layer, such as titanium tungsten or chromium, and a conductive layer such as copper over the barrier layer. Preferably the conductive layer is a plating layer and the thickness thereof can be increased by plating.

SZLUFCIK J ET AL: "Low-Cost Industrial Technologies of Crystalline Silicon Solar Cells" PROCEEDINGS OF THE IEEE, IEEE. NEW YORK, US, vol. 85, no. 5, 1 May 1997 (1997-05-01), pages 711-730, XP011043842 ISSN: 0018-9219.

RUTHE D ET AL: "Etching of CulnSe2 thin films-comparison of femtosecond and picosecond laser ablation" APPLIED SURFACE SCIENCE, ELSEVIER, AMSTERDAM, NL, vol. 247, no. 1-4, 15 July 2005 (2005-07-15), pages 447-452, XP025284205 ISSN: 0169-4332 [retrieved on 2005-07-15].

USRE37512 describes a method of preparing solar cell front contacts.

### SUMMARY OF THE INVENTION

It is the object of the present invention to improve methods and tools for producing photovoltaic devices that convert solar energy to electrical energy. This object is achieved by providing a method for producing a photovoltaic device according to claim 1 and a system for producing a photovoltaic device according to claim 9. Embodiments of the invention are set forth in the dependent claims.

In accordance with an embodiment of the present invention, a laser-based ablation device is utilized to pattern the passivation layer. The laser-based ablation device generates laser pulses that have sufficient energy to ablate (remove) portions of the passivation layer in a way that forms contact openings without the need for cleaning (e.g., rising and drying) the passivation surface or other processing prior to metallization, thus increasing production through-put and yields by avoiding the need for wafer handling between patterning and metallization. The contact openings generated by laser-based ablation devices are substantially smaller than the minimum openings produced by conventional screen printing processes. The laser-based ablation device also facilitates removal of the passivation without significantly altering the thickness or doping profile of the underlying silicon layer. In a specific embodiment, the laser-based ablation device is a femtosecond laser, which facilitates shallow ablation with a minimum of debris. A particular advantage of femtosecond laser pulses is that the power density can be sufficiently high that the electric field of the optical pulse becomes comparable to the inter-atomic fields of the atoms in the material. This becomes important in the present application because it is desired to ablate the passivation without disturbing the underlying semiconductor. The passivation is typically a nitride or oxide layer and as such has a large band gap and it typically transparent. Ordinarily, light would pass through the passivation and become adsorbed by the underlying semiconductor. With sufficiently high power density, the interaction of light with matter alters such that even ordinarily transparent materials become adsorbing. Multiple photons can be adsorbed on a site in the material before the excited electronic states can relax. By adsorbing energy in the dielectric passivation, that surface layer can be selectively ablated. For a photovoltaic device with a shallow layer of dopants, this selective surface ablation is advantageous. The n-type emitter of a typical screen printed solar cell for example is only about 200 to 300 nm thick. If an ablated contact opening in the passivation were to extend through the emitter, then the metallization could form a shunt to the p-type material below the emitter, ruining the device.

In a specific embodiment, a front surface contact cell-type device is produced using a laser-based ablation device such that the laser pulses are directed across the passivation using a rotating mirror-type scanning apparatus. In this embodiment, the predetermined scan pattern defined by a main scanning direction of the rotating mirror is perpendicular to the subsequently formed grid lines of the front surface contact cell device, thereby maximizing the contact opening placement accuracy. The precise control of the timing of the laser pulses is used to place the ablated contacts at the desired locations. In one embodiment of the method according to claim 1, utilizing the direct-write metallization apparatus to deposit the contact portion into each of the plurality of openings comprises depositing a first, silicide-forming metal into each of the openings. In a further embodiment utilizing the direct-write metallization apparatus further comprises depositing a second metal onto the first metal, wherein the second metal has a greater electrical conductivity than the first metal. In a further embodiment utilizing the direct-write metallization apparatus to deposit the contact portion comprises utilizing at least one of an inkjet-type printhead and a dispensing nozzle. In a further embodiment utilizing the direct-write metallization apparatus to deposit the contact portion comprises printing a seedlayer inside each opening and in a predetermined pattern on the passivation layer, and wherein the method further comprises electroless plating a second metal onto the seedlayer. In a further embodiment utilizing the direct-write metallization apparatus to deposit the contact portion comprises utilizing the extrusion-type dispensing nozzle to simultaneously deposit a lower metal layer on the surface of the semiconductor wafer inside each said opening, and an upper metal layer on the lower metal layer. In a further embodiment depositing the lower metal layer comprises depositing a first paste comprising nickel, and depositing the upper metal layer comprises depositing a second paste comprising one of silver and copper. In a further embodiment simultaneously depositing the lower and upper metal layers further comprises simultaneously depositing a solder wetting material over the second metal layer.
In a further embodiment utilizing said at least one of an inkjet print head and a dispensing nozzle further comprises:
utilizing a first direct-write metallization apparatus to deposit said contact portion into each of the plurality of openings; and
subsequently utilizing a second direct-write metallization apparatus to depositing said conductive lines onto said contact portions.
In a further embodiment the solar power generating device comprises a backside contact cell.
In a further embodiment the semiconductor wafer comprises one of crystalline silicon, amorphous silicon, CdTe, or CIGS (copper-indium-gallium-diselenide).

In accordance with another embodiment of the present invention, an inkjet-type printing apparatus is utilized to deposit contact material and/or conductive material into each of the contact openings. Inkjet-type printing apparatus provide a highly accurate and efficient mechanism for performing the required deposition, and also provides an advantage over conventional methods by allowing the accurate deposition of two or more materials into each contact opening. In one embodiment, the contact material is a silicide-forming metal (e.g., nickel) that facilitates both low resistance contact to the underlying silicon, and also minimizes diffusion into the silicon, thus enabling lighter wafer doping than is possible using conventional silver-frit-based pastes. After the contact material is deposited into the contact openings, a highly conductive metal (e.g., copper) is printed on top of the contact material and over the passivation material, thereby forming highly conductive current-carrying metal lines that are coupled to the underlying silicon wafer by way of the low resistance contact portions.

In accordance with another embodiment of the present invention, an extrusion-type dispensing apparatus is utilized to deposit the contact material and/or conductive (metal line) material into the contact openings or over the passivation surface. In one embodiment, grid lines for a front surface contact cell-type device include a high aspect extruded metal line supported on each side by a co-extruded transparent material. In another embodiment, one or more contact materials are co-extruded below the metal line material. In another embodiment, a solder wetting material is also co-extruded over the metal line material.

In accordance with another embodiment of the present invention, two or more direct-write metallization apparatus are utilized in sequence to provide a multilayer metallization structure. In one embodiment, an inkjet-type printing apparatus is utilized to print relatively thin contact material portions into each contact opening, and an extrusion-type dispensing apparatus is utilized to print relatively thick metal lines on the passivation surface between selected contact openings. This approach greatly increases production throughput.

In accordance with another embodiment of the present invention, a contact/seedlayer is printed onto the wafer using an inkjet-type printing apparatus, and a subsequent plating process is utilized to form a highly conductive metal layer, which is self-aligned to the contact/seedlayer. This approach improves throughput by minimizing the printing time (i.e., because only a thin contact/seedlayer is required), and by utilizing electroless plating, which can be performed on several wafers simultaneously, to form the thick metal lines.

In accordance with another embodiment of the present invention, a processing system for producing a photovoltaic device includes a fixed base, at least one non-contact patterning apparatus fixedly connected to the base, at least one direct-write metallization apparatus also fixedly connected to the base, and a conveyor mechanism for supporting the photovoltaic device wafer during processing by both the non-contact patterning apparatus and the direct-write metallization apparatus, and for conveying the wafer between the non-contact patterning apparatus and the direct-write metallization apparatus. In a preferred embodiment, the wafer is held on the conveyor by a vacuum chuck. In one embodiment, processing apparatus and conveyor mechanism transport and process the device wafers in a "hard tooled" feature registration such that the device wafers remain attached to the conveyor mechanism, and the metallization deposited by the direct-write metallization apparatus is automatically aligned with the contact holes patterned by the non-contact patterning apparatus (i.e., without the need for an intermediate alignment or calibration process). In another embodiment, a sensor is positioned between the non-contact patterning apparatus (or between two non-contact patterning apparatus) and the direct-write metallization apparatus to facilitate a highly accurate metallization process. This approach provides the flexibility of using inkjet-type printing apparatus and/or paste dispensing nozzles with relatively imprecise print element placement.
In one embodiment of the system according to claim 9, wherein the non-contact patterning apparatus, the direct-write metallization apparatus and the conveyor mechanism are fixed attached to a base, and the conveyor mechanism includes means for securing the semiconductor wafer such that the semiconductor wafer maintains a hard tooled fixed registration relative to the non-contact patterning apparatus and the direct-write metallization apparatus during conveyance between the non-contact patterning apparatus and the direct-write metallization apparatus.
In a further embodiment the 2 system further comprises means for coordinating a location of each contact opening generated by the non-contact patterning apparatus with an expected position of a contact portion deposited by the direct-write metallization apparatus.
In a further embodiment the system further comprises means for coordinating a location of each contact opening generated by the non-contact patterning apparatus with an expected position of a contact portion deposited by the direct-write metallization apparatus.

In accordance with another embodiment of the present invention, a front surface contact-type photovoltaic device includes grid lines formed in the manner described above to include a high aspect central metal line, and transparent support portions formed on each side of the central metal line. An advantage of this arrangement is that conduction through the grid lines is maximized while interruption of light passing into the cell is minimized.

### BRIEF DESCRIPTION OF THE DRAWINGS

These and other features, aspects and advantages of the present invention will become better understood with regard to the following description, appended claims, and accompanying drawings, where:
Fig. 1 is a flow diagram showing a simplified method for producing photovoltaic devices according to an embodiment of the present invention;
Fig. 2 is a simplified diagram showing an assembly for producing photovoltaic devices according to another embodiment of the present invention;
Fig. 3 is a perspective view showing a portion of a photovoltaic device during a patterning portion of the production process of Fig. 1 according to a specific embodiment;
Fig. 4 is a top plan view depicting a laser-based patterning apparatus utilized in the patterning portion according to an embodiment of the present invention;
Fig. 5 is a perspective view showing a portion of a photovoltaic device during a first phase of a metallization portion of the production process of Fig. 1 according to a specific embodiment of the present invention;
Fig. 6 is a perspective view showing a portion of a photovoltaic device during a second phase of the metallization portion according to another specific embodiment of the present invention;
Fig. 7 is a perspective view showing an inkjet-type printing apparatus utilized during the metallization portion in accordance with a specific embodiment of the present invention;
Fig. 8 is a simplified side-view diagram showing an extrusion-type dispensing apparatus utilized during the metallization portion in accordance with another specific embodiment of the present invention;
Fig. 9 is a perspective view showing a portion of a photovoltaic device during a seedlayer (metallization) formation process according to another specific embodiment of the present invention;
Fig. 10 is a perspective view showing the photovoltaic device of Fig. 9 after a subsequent electroless plating process;
Fig. 11 is a perspective view showing a portion of a front surface contact cell-type photovoltaic device produced in accordance with another embodiment of the present invention;
Fig. 12 is a top plan view depicting a laser-based patterning apparatus and device wafer during the patterning portion in accordance with another specific embodiment of the present invention;
Fig. 13 is a cross-sectional side view showing an extrusion nozzle utilized during a metallization portion according to another specific embodiment of the present invention;
Figs. 14(A) and 14(B) are cross-sectional side views showing grid lines formed on a photovoltaic device according to alternative embodiments of the present invention;
Fig. 15 is a cross-sectional side view showing a simplified extrusion nozzle and a multilayer grid line in accordance with another embodiment of the present invention;
Fig. 16 is a simplified diagram showing a portion of a processing system for producing photovoltaic devices according to another embodiment of the present invention;
Fig. 17 is a cross-sectional side view showing a simplified backside contact cell-type photovoltaic device formed in accordance with another embodiment of the present invention;
Fig. 18 is a simplified diagram showing a portion of a processing system for producing photovoltaic devices according to a specific embodiment of the present invention;
Fig. 19 is a simplified diagram showing a portion of a processing system for producing photovoltaic devices according to another specific embodiment of the present invention; and
Fig. 20 is a simplified diagram showing a portion of a processing system for producing photovoltaic devices according to yet another specific embodiment of the present invention.

### DETAILED DESCRIPTION OF THE DRAWINGS

The present invention relates to an improvement in photovoltaic devices (e.g., solar cells) that can be used, for example, to convert solar power into electrical energy. The following description is presented to enable one of ordinary skill in the art to make and use the invention as provided in the context of a particular application and its requirements. As used herein, directional terms such as "upper", "lower", "side", "front", "rear", are intended to provide relative positions for purposes of description, and are not intended to designate an absolute frame of reference. Various modifications to the preferred embodiment will be apparent to those with skill in the art, and the general principles defined herein may be applied to other embodiments. Therefore, the present invention is not intended to be limited to the particular embodiments shown and described, but is to be accorded the widest scope consistent with the principles and novel features herein disclosed.

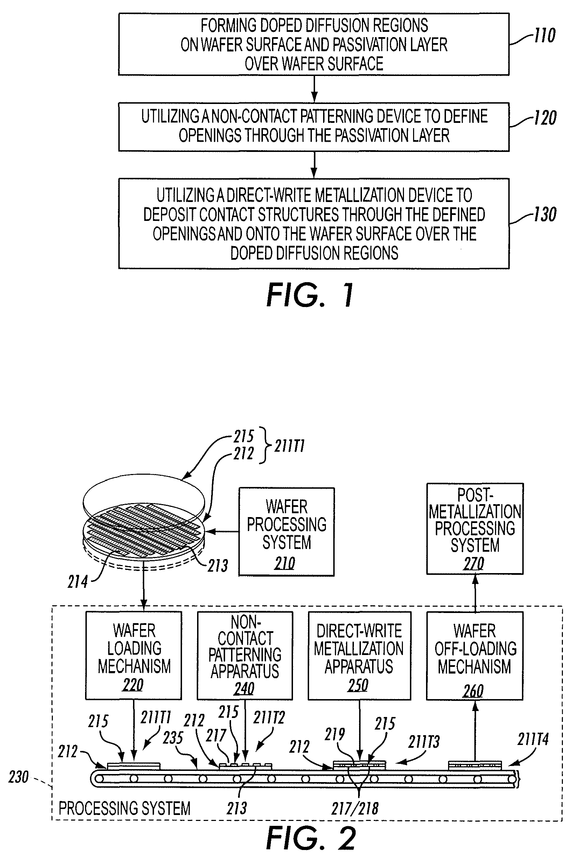

Fig. 1 is a flow diagram indicating the basic processing steps utilized to produce photovoltaic devices in accordance with an embodiment of the present invention. Fig. 2 is a simplified block diagram illustrating an assembly 200 for processing photovoltaic devices using the method of Fig. 1 in accordance with another embodiment of the present invention.

Referring to Fig. 2, the method proposed herein is performed after an upper surface 213 of a semiconductor (e.g., monocrystalline or multi-crystalline silicon) wafer 212 has been treated to include one or more doped (e.g., diffusion) regions 214, and a blanket passivation (electrically insulating) layer 215 has been formed on upper surface 213 over doped regions 214. As referred to herein, the photovoltaic device is generally as "device 211", and at each stage of the processing cycle is referenced with an appended suffix indicating the device's current processing stage (e.g., prior to and during loading, the device is referenced as "device 211T1", with the suffix "T1" indicating a relatively early point in the process cycle). The operations used to provide device 211T1 with doped regions 214 and covering surface 213 with passivation layer 215 (block 110 in Fig. 1) are performed using well-known processing techniques, and thus the equipment utilized to produce device 211T1 is depicted generally in Fig. 2 as wafer processing system block 210.

After initial treatment, device 211T1 is transferred to an optional loading mechanism 220 of a processing system (tool) 230, which loads device 211T1 onto a conveyor 235. In accordance with the present invention, processing system 230 includes at least one non-contact patterning device 240 and at least one direct-write metallization device 250 that are sequentially arranged in the conveying direction of conveyor 235 (e.g., to the right in Fig. 2). As used herein, "direct-write metallization device" is defined as a device in which the metallization material is ejected, extruded, or otherwise deposited only onto the portions of the wafer where the metallization is needed (i.e., without requiring a subsequent mask and/or etching process to remove some of the metallization material). Processing system 230 also includes an optional wafer off-loading mechanism 260 for removing processed wafers 211T4 from conveyor 235 after processing by direct-write metallization apparatus 250 is completed in accordance with the description provided below. Optional wafer loading mechanism 220 and wafer off-loading mechanism 260 operate in a manner well known to those skilled in the art, and therefore are not described in additional detail herein. The removed devices are then transferred to a post-metallization processing system 270 for subsequent processing in the manner described below.

Conveyor 235 is depicted in Fig. 2 as a belt-type conveyor mechanism in which an upward-facing belt portion receives and conveys devices 211T1 to non-contact patterning device 240 and direct-write metallization device 250. The use of belt-like conveyor 235 in the depicted generalized system is intended to be exemplary and not limiting.

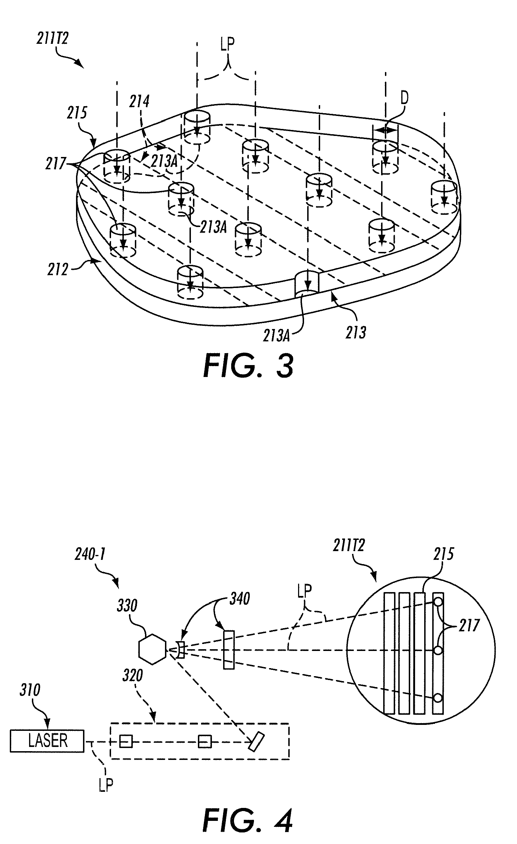

In accordance with a first aspect of the present invention, as indicated in block 120 in Fig. 1 and with reference to Fig. 2, non-contact patterning apparatus 240 is utilized to define a plurality of openings 217 through passivation layer 215, whereby each opening 217 exposes a corresponding one of said one or more regions on surface 213 of the semiconductor wafer 212. As depicted in Fig. 3, in accordance with a presently preferred embodiment of the invention, non-contact patterning device 240 is a laser-based ablation device capable of generating laser pulses LP of sufficient energy to ablate (remove) portions of passivation layer 215 to form openings 217 that expose surface portions 213A of substrate 212 without the need for cleaning or other processing prior to metallization. An advantage of using laser ablation, when compared to methods such as chemical etching, is that wafer 212 need not be rinsed and dried after the ablation is performed. Avoidance of rinsing and drying steps enables the rapid and successive processing of the contact opening following by the metallization. The avoidance of rinsing and/or other post-ablation treatment is essential to using a shared-conveyor 235 for the etching and metallization processes. In particular, rinsing and drying after ablation/etching would generally preclude the precise machine tooled registration of the subsequent metallization. Rinsing and drying also contribute to wafer breakage. In a possible alternative embodiment, a particle-beam generating apparatus may be used in place of the laser-based patterning.

In accordance with a specific embodiment shown in Fig. 4, non-contact patterning device 240 includes a scanning-type laser apparatus 240-1 in which laser pulses LP generated by a laser 310 are directed by way of beam conditioning optics 320 onto a rotating mirror 330 and through a suitable scan lens 340 such that laser pulses LP are directed in a predetermined scan pattern across passivation layer 215 (e.g., silicon nitride). Laser apparatus 240-1 is similar to those used for writing the electrostatic image on the photoreceptor of a xerographic print engine. The throughput of such a laser-processing tool can be on the order of one wafer per second, which is a comparable printing speed to a low to medium range laser printer. The spot size (i.e., the average diameter D of openings 217) determines the size of each ablated contact opening 217. This size is typically in the range of 5 to 50 microns in diameter. These dimensions are well below the sizes typically achievable by either screen-printing an etchant paste, or by etching through a screen-printed resist mask.

In accordance with a specific embodiment, laser 310 is a Coherent Inc. model AVIA 266-300 Q-switched Nd-YAG operating at a pulse repetition rate on the order of 100 KHz. The fluence needed to ablate the surface passivation is on the order of 1 Joule/cm2. The pulse length of the laser is on the order of tens of nanoseconds. The wavelength can be on the order of 266 nm. The short pulse and wavelength of such lasers ensure that the energy is deposited near the surface and any melting in the silicon wafer 212 is short lived. This minimizes any change to the doping profile of the diffusion regions. The energy of a 266 nm photon is 4.66 electron Volts. Although the bandgap of silicon nitride passivation layer 215 varies over a wide range, this photon energy is comparable to the band gap of silicon nitride in its most transparent forms (see "Optical properties of silicon nitride films deposited by hot filament chemical vapor deposition", Sadanand V. Deshpande and Erdogan Gulari, J, Appl. Phys. 77 (12), 15 June 1995). These highly energetic photons are absorbed in the surface passivation and/or in the topmost nanometers of the underlying silicon. A lightly doped emitter will have a phosphorous diffusion depth of about 200 nm, a sheet resistance on the order of 100 Ohms/sq., and a non-degenerate level of dopant at the physical surface. Silicon is a good thermal conductor causing rapid quenching of the silicon melt formed below the surface of the passivation. Suitable control of the process conditions allows removal of the silicon nitride passivation without significantly altering the thickness or doping profile of the underlying silicon layer.

In an alternative embodiment of the invention, laser-based non-contact patterning apparatus 240-1 includes a femtosecond laser. The advantage of using a femtosecond laser is that the laser energy can be deposited in a timeframe that is faster than the time required for the material to reach thermal equilibrium. Thus, passivation material can be ablated with less debris.

Returning to Figs. 1 and 2, after patterning of passivation layer 215 is completed, devices 211T2 are transported via conveyor 235 to a point located below direct metallization apparatus 250, where direct-write metallization apparatus 250 is utilized to deposit at least a contact (metallization) portion 218 into each opening 217 (block 130; Fig. 1). Contact portions 218 facilitate electrical connection of current-carrying conductive lines 219 to the diffusion regions formed in wafer 212. Upon completion of the metallization process by direct-write metallization apparatus 250, devices 211T3 are transported to optional wafer-off loading mechanism 260.

Conventional wisdom suggest that, upon forming openings 217 through passivation layer 215, metallization would then proceed using essentially the same silver metallization that is used in nearly all of today's solar cells. Silver, however, diffuses rapidly in silicon and would not make a good metal contact to a lightly doped emitter because of the risk of the silver shunting through to the far side of the junction. The silver contact also requires heavy emitter doping. Silver is also expensive in comparison to other metals such as copper and tin.

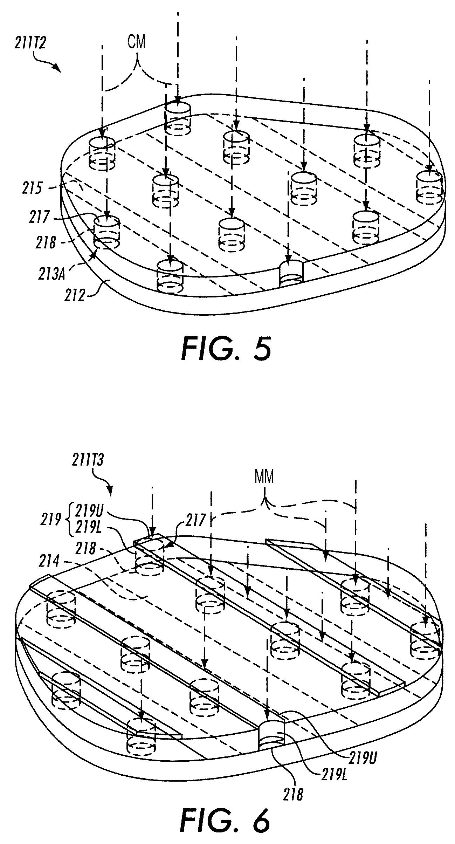

Fig. 5 depicts the sequential deposition of contact material CM from direct-write metallization apparatus 240 (not shown) into each opening 217 formed in passivation layer 215 such that contact portions 218 are formed directly on exposed portions 213A of substrate 212. Note that contact portions 218 do not necessarily fill openings 215. In accordance with another aspect of the present invention, contact portions 218 include a silicide-forming metal that diffuses slowly in silicon. Specific examples of metals currently believed to be suitable for this purpose include nickel (Ni), cobalt (Co) and titanium (Ti). These metals are not only less expensive than silver but they are also demonstrated to enable a lower contact resistance by a factor of 30 or more (see M.M. Hilali, A. Rohatgi and B. To, "A Review and Understanding of Screen-Printed Contacts and Selective-Emitter Formation" August 2004 • NREL/CP-520-36747, presented at the 14th Workshop on Crystalline Silicon Solar Cells and Modules, Winter Park, Colorado, August 8-11, 2004). The ink or paste bearing the silicide forming metal may optionally contain a dopant such as phosphorous or boron to provide additional doping of the contact region during the thermal processing steps applied to the deposited metal.

As depicted in Fig. 6, in accordance with an embodiment of the present invention, direct-write metallization apparatus 250 includes a second deposition head or nozzle for depositing a second (relatively highly conductive) metal MM into openings 215 to form a conductive plug 219L on contact portions 218, and optionally depositing the second metal on passivation layer 215 to form metal lines 219U in order to complete the production of current-carrying conductive lines 219. In accordance with an aspect of the invention, second metal MM different from contact metal CM (discussed above) in that, instead of being selected for its ability to form a silicide on silicon, second metal MM is selected for its electrical conductance, and as such typically has a greater electrical conductivity than contact metal CM. In one specific embodiment, second metal MM comprises copper, which is inexpensive and has excellent conductivity, and is also easily soldered. Note, however, that if copper is used as contact metal CM and allowed to diffuse into wafer 212, the copper will create recombination centers within the device, and these will degrade cell performance. Therefore, it is desired that each current-carrying conductive lines 219 include both a silicide contact structure 218 (e.g., nickel silicide) disposed at the silicon/metal interface, and a low resistance conductor 219L/219U (such as copper) formed on contact metal 218. In this case, the nickel silicide contact structure 218 also acts as a diffusion barrier to prevent poisoning of the silicon by the copper conductive plug 219L.

A preferred source of Ni is ink composed on suspended particles of nanophase Ni.

It will be appreciated that the immediate execution of metallization following the formation of contact openings 217 provides the additional advantage of limiting the air-exposure of exposed portions 213A. This short-duration exposure prevents the formation of an oxidized silicon layer that can otherwise interfere with the formation of the subsequently formed silicide (discussed below). Subsequent heating of the device to drive off volatile components of the ink or paste and a temperature cycle of the device, optionally in a reducing ambient such as hydrogen or forming gas, completes the contact.

In accordance with another aspect of the present invention, the one or more metallization materials are deposited onto the patterned semiconductor wafer using one of an inkjet-type printhead and an extrusion-type dispensing nozzle, as described in the following exemplary embodiments. By arranging such non-contact, direct-write metallization apparatus immediately downstream of the laser-based non-contact patterning apparatus (described above), the present invention enables the precise placement of metallization over the just-formed contact openings without an expensive and time-consuming alignment step.

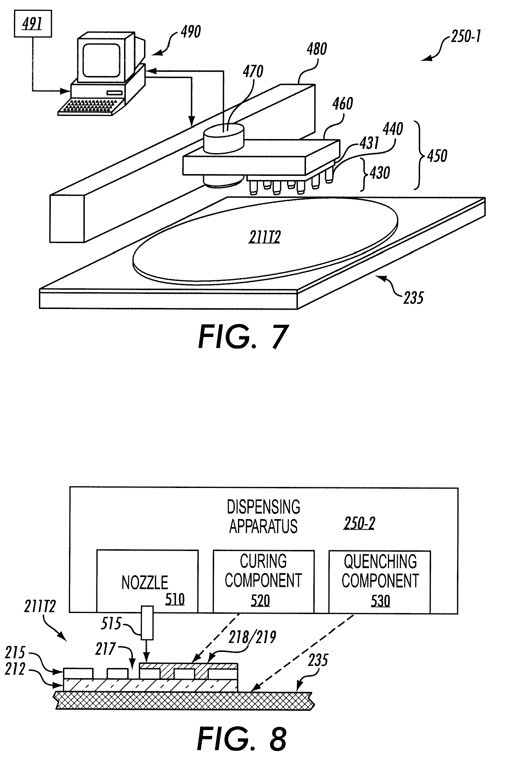

Fig. 7 is a perspective view of an inkjet-type printing apparatus 250-1 for printing at least one of contact structure 218 and conductive lines 219 onto wafer 211T2 in the manner described above according to an embodiment of the present invention. Such inkjet-type printing apparatus are disclosed, for example, in co-owned U.S. Patent Application Number 11/282882, filed November 17th, 2005, titled "Extrusion/Dispensing Systems and Methods" with inventors David K. Fork and Thomas Hantschel, which is incorporated herein in its entirety. Printing apparatus 250-1 is mounted over conveyor 235 (partially shown), which supports wafer 211T2, and includes a print assembly 450 mounted to a printing support structure 480, and a control circuit 490 (depicted as a computer/workstation).

Print assembly 450 includes a print head 430 and an optional camera 470 (having high magnification capabilities) mounted in a rigid mount 460. Print head 430 includes one or more ejectors 440 mounted in an ejector base 431. Ejectors 440 are configured to dispense droplets of the appropriate metallization material in a fluid or paste form onto wafer 211T2 in the manner described above.

Control circuit 490 is configured in accordance with the approaches described below to provide appropriate control signals to printing support structure 480. Data source 491 can comprise any source of data, including input from an in-line sensor (as described below), a networked computer, a pattern database connected via a local area network (LAN) or wide area network (WAN), or even a CD-ROM or other removable storage media. The control signals provided by computer/workstation 490 control the motion and printing action of print head 430 as it is translated relative to wafer 211T2.

Note that the printing action can be provided by printing support structure 480, by conveyor 235, or by both in combination. Computer/workstation 490 is optionally coupled to receive and process imaging data from camera 470. In one embodiment, camera 470 provides both manual and automated calibration capabilities for printing apparatus 250-1.

By properly calibrating and registering printing apparatus 250-1 with respect to wafer 211T2, the metallization pattern (e.g., contact portions 218 and metal portions 219L and 219U, described above with reference to Fig. 6) printed by printing apparatus 250-1 can be precisely aligned with openings 215 formed in passivation layer 215, thereby ensuring a high-yield manufacturing process. According to an embodiment of the invention, apparatus calibration can be accomplished with a video camera microscope (such as camera 470) having an optical axis position that is fixed relative to the ejector positions of the print head.

Fig. 8 is a simplified side-view showing an extrusion-type dispensing apparatus 250-2 for printing at least one of contact structure 218 and conductive lines 219 onto wafer 211T2 in the manner described above according to another embodiment of the present invention. Such extrusion-type dispensing apparatus are disclosed, for example, in co-owned and co-pending US Patent Application No. 11/282882, entitled "EXTRUSION/DISPENSING SYSTEMS AND METHODS" [Atty docket no 20040932-US-NP], which is incorporated herein by reference in its entirety. Extrusion-type dispensing apparatus 250-2 is mounted over conveyor 235 (partially shown), which supports device 211T2, and includes a dispensing nozzle (applicator) 510, an optional curing component 520, and an optional quenching component 530. In one embodiment, dispensing nozzle 510 includes one or more openings 515, and is configured to concurrently apply two or more metallization materials (e.g., a silicide-forming metal paste and a high-conductivity metal paste) into openings 217 and over passivation layer 215 to form contact portions 218 and conductive lines 219. The materials are applied through pushing and/or drawing techniques (e.g., hot and cold) in which the materials are pushed (e.g., squeezed, etc.) and/or drawn (e.g., via a vacuum, etc.) through dispensing nozzle 510 and out one or more openings 515. Nozzle 510 can be micro-machined with various channels and structures that receive and converge individual materials. For instance, nozzle 510 can include N channels, where N is an integer equal to or greater than one, for merging materials within the nozzle 510 into a single flow dispensed through opening 515. Each of the N channels can be used for introducing a different material and/or multiple channels can be used for introducing a substantially similar material. Where nozzle 510 includes a single channel, the different material can be introduced through similar and/or different ports into the channel. Each channel can extend through a length (e.g., the entire length or a subset thereof) of nozzle 510. For instance, one or more of the N channels can be designed to be shorter than the length of nozzle 510, but relatively longer than an entrance length in order to produce laminar flow, wherein flow velocity is stabilized prior to merging materials. This can be achieved through known micro-machining techniques such as deep reactive ion etching, wafer bonding, etc. Creating nozzle 510 for laminar flow mitigates and/or minimizes mixing of materials as the materials traverse through nozzle 510 and out of opening 515. The N channels may also be shaped to counteract the effects of surface tension on the materials as they progress from nozzle 510 to device 211T2. Each channel may be uniquely and/or similarly shaped, including uniform and/or non-uniform shapes. Similar to the inkjet-type printing apparatus (discussed above), nozzle 510 may be moved over device 211T2 during dispensing of the materials in order to produce the desired metallization structures. Curing component 520 and/or quenching component 530 may be utilized to limit the tendency for the dispensed materials to intermix after extrusion. For example, curing component may be used to cure the dispensed materials by thermal, optical and/or other means upon exit from nozzle 510. Alternatively, quenching component 530 can be used to cool wafer 212, thereby cooling and solidifying the dispensed materials immediately after extrusion.

In one embodiment, the metallization applied over the contact openings by the direct write metallization devices described above (i.e., inkjet-type printing apparatus 250-1 and/or extrusion-type dispensing apparatus 250-2) may, after subsequent thermal processing, serve as the complete cell metallization in preparation for tabbing and stringing the cells for module assembly. Alternatives to tabbing may also be applicable, for example the adhesive bonding of the cells to a flexible backplane (see "Fast and easy single step module assembly for back-contacted C-Si solar cells with conductive adhesives", Bultman, J.H., Eikelboom, D.W.K., Kinderman, R., Tip, A.C., Tool, C.J.J., Weeber, A.W. (ECN, Petten (Netherlands) Nieuwenhof, M.A.C.J. van den (TNO, Eindhoven (Netherlands)), Schoofs, C., Schuurmans, F.M. (Shell Solar Energy BV, Helmond (Netherlands)) ECN-RX--03-019 (May 2003)).

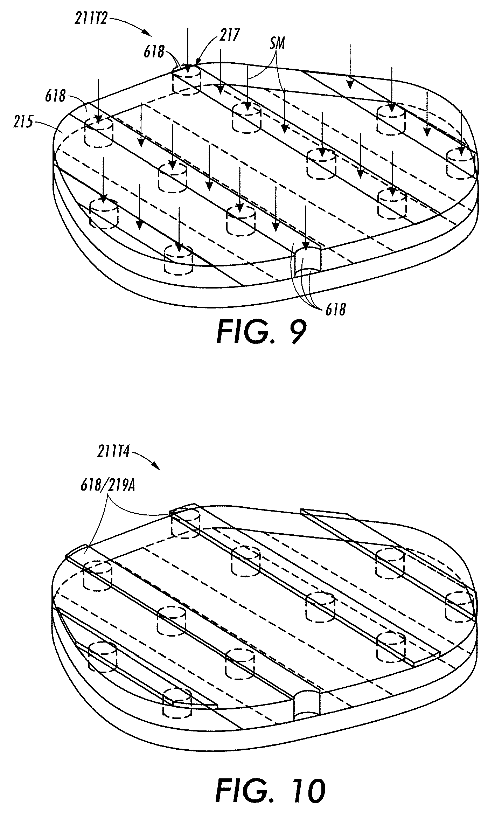

Fig. 9 depicts a metallization process according to a specific embodiment of the present invention wherein one or more of the direct write metallization devices described above (i.e., inkjet-type printing apparatus 250-1 or extrusion-type dispensing apparatus 250-2) are utilized to print a seedlayer metallization material SM (e.g., Ni, Cu or Ag) inside each opening 217 and in a predetermined pattern on passivation layer 215 to form one or more seedlayers 618. As depicted in Fig. 10, after removal from the conveyor, device 211T4 is then subjected to a plating process, whereby conductive lines 219A are formed on seedlayers 618 using known techniques. This embodiment provides an inherently self-aligned process particularly well suited to fabrication of back contact solar cells. In a preferred embodiment, seedlayer metallization material SM would be jet printed, fired, and then plated with additional metal.

As set forth in the following exemplary embodiments, the processing methods described above may be modified to optimize the production of both front surface contact cell-type photovoltaic devices and backside contact cell-type photovoltaic devices.

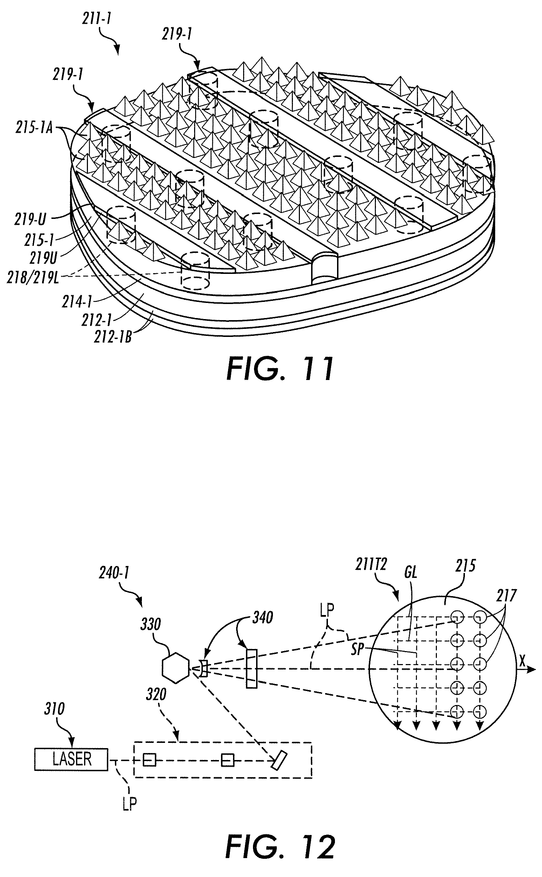

Fig. 11 is a perspective view showing a front surface contact cell-type photovoltaic device 211-1 that is produced in accordance with an embodiment of the present invention. Device 211-1 generally includes a P-type single crystalline silicon wafer (substrate) 212-1 disposed between a lower (back) contact structure 212-1B and a continuous N-type diffusion region 214-1, which is formed in an upper surface of wafer 212-1. Passivation layer 215 is formed over diffusion region 214-1, and pyramid-like light trapping structures 215-1A are formed on an upper surface of passivation layer 215-1 according to known techniques. In addition, current-carrying conductive grid lines 219-1 are formed over passivation layer 215. Grid lines 219-1 are formed using any of the methods described above (e.g., to include a contact portion 218, lower metal conductive plugs 219L, and metal grid line portions 219U. Note that gird lines 219-1 are typically narrow parallel metal lines that extend substantially across the surface of passivation layer 215. The operating principles of front surface contact cell-type photovoltaic device 211-1 are essentially identical to conventional front surface contact cells and are known to those skilled in the art.

Referring to Fig. 12, in accordance with a specific embodiment of the present invention, front surface contact cell-type photovoltaic device 211-1 is fabricated using scanning-type laser apparatus 240-1 (described above with reference to Fig. 4), in which laser pulses LP generated by laser 310 are directed such that predetermined scan patterns SP (indicated by dashed lines on device 211T2) defined by a main scanning direction of rotating mirror 340 are perpendicular (orthogonal) to the grid lines GL (which at this point in the fabrication process are defined solely by linearly-arranged contact openings 217 formed in passivation layer 215). It will be appreciated that scanning-type laser apparatus 240-1 will have a fast (main) scanning direction corresponding to the direction laser pulses LP are moving as they are swept by rotating mirror 340, and apparatus 240-1 will have a slow scan direction corresponding to the direction (depicted by arrow X) of motion of the conveyed device 211T2. It is common that a laser scanning apparatus 240-1 will have its finest addressing capability in the fast scanning direction. Precise timing of laser pulses LP enables precise positioning of the gridline's contact openings 217. In on example, timing stability of greater than 64 nsec enables addressing to within +/- 10 microns. This example system is directed at opening a series of 10 micron contact holes on a spacing of 50 microns in gridlines spaced 1.8 mm apart. In the preferred embodiment, during each laser scan, one additional hole is etched for each of the 69 gridlines on the cell. The laser is operated at a repetition rate below 100 kHz.

In accordance with a preferred embodiment, laser scanning apparatus 240-1 is controlled to form contact openings 217-1 in the form of spaced-apart openings 217-1, which underlie the gridlines 219-1 (i.e., as indicated in Figs. 11 and 12). An exemplary embodiment for writing contact openings is summarized in Table 1 (below). In this table the "slow" and "fast" scan speeds refer to the speed the laser would need to scan if it were going parallel to or perpendicular to the grid line respectively.

**Table 1**

| **Gridline Design** | | | | |
|---|---|---|---|---|
| Pulse Width | 25 nsec | or less | Pulse Power | 10 microJoules |
| Power Density | 10 J/cm2 | | Shots | 172500 /wafer |
| Spot Size | 10 microns | | Repetition Rate | 0.08625 MHz |
| Wafer Time | 2 sec | | Timing stability | 64.41 nsec |
| Wafer Size | 125 mm | | Laser Power | 0.86 Watts |
| Hole spacing | 50 microns | | Gridlines | 69.00 |
| Gridline spacing | 1.8 mm | | | |
| Possible Laser Source: | Coherent AVIA 266-300 | | S(scan Speed low) | 4340.28 mm/sec |
| Wavelength | 266 nm | | S can Speed (fast) | 155250 mm/sec |

In an alternative embodiment, continuous trenches (not shown) are formed (instead of linearly arranged contact openings 217-1) by laser pulses LP that are used to provide contact between the grid lines and the N-type diffusion region.

In accordance with another alternative embodiment, extrusion-type dispensing apparatus 250-2 (described above with reference to Fig. 8) is utilized with a corresponding nozzle to produce the grid lines described in the following examples.

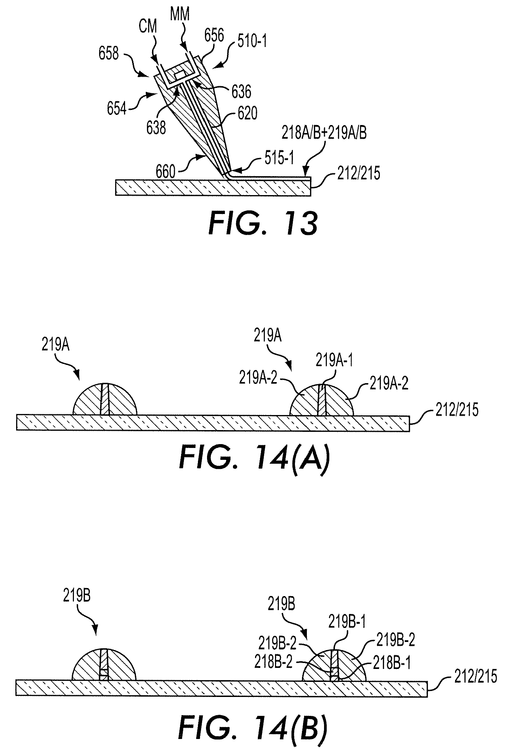

In accordance with an exemplary embodiment depicted in Fig. 13, a dispensing nozzle 510-1 is utilized to simultaneously deposit a contact (lower metal) layer (218A or 218B, as described below) on the surface of wafer 212 and/or passivation layer 215, and one or more conductive (upper) metal layers (219A or 219B) on contact layer 218A/B. In this example, the various layers of the grid lines are co-extruded high aspect ratio metals that are described in co-pending US Patent Application Serial No. 11/282882 (cited above).

Fig. 13 illustrates a nozzle 510-1 in which two or more different materials on the wafer 212 and passivation layer 215. Nozzle 510-1 includes the manifold 620 that includes channels, which are fabricated to facilitate creating laminar flow in order to merge materials (i.e., contact material CM and metal material MM) received in each channel within the manifold 620 into a single flow of separate materials (with material to material contact) while mitigating mixing of the materials. The channels are associated with either ports 636 or ports 638, which are used to introduce the materials into the manifold 620. The two different materials are introduced into the manifold 620 in an interleaved manner such that adjacent channels are used for different materials. The materials traverse (e.g., via a push, a pull, etc. technique) through corresponding channels and merge under laminar flow within the manifold 20 to form a single flow of materials that are extruded through opening 515-1 onto wafer 212 or passivation layer 215.

Fig. 14(A) is a cross-sectional end view showing a high aspect ratio grid line 219A that is extruded using nozzle 510-1 (Fig. 13) in accordance with an embodiment of the present invention. Grid line 219A includes an elongated central metal structure 219A-1 having a relatively narrow width and a relatively large height (i.e., in the direction extending away from the passivation layer/wafer), and transparent supports 219A-2 formed on one or both sides of central metal structure 219A-1. In one embodiment, central metal structure 219A-1 includes a highly conductive metal such as copper or silver, and transparent supports 219A-2 comprise a low melting glass optimized for its transparency and adherence to the device surface. Although not shown, a separate print head may be utilized to print a contact structure inside each contact opening before the extrusion of grid line 219A. The benefit of this structure is that it allows the production of front surface contact cell-type devices that produce minimal interruption of sunlight passing into the device. In one specific embodiment, contact portion 218A comprising a nickel bearing paste that is deposited at the grid line-substrate interface (i.e., in the contact openings and on passivation layer 215), and upper portion 219A consists of a more conductive metal such as copper or silver.

Fig. 14(B) is a cross-sectional end view showing another high aspect grid line 219B in accordance with another embodiment of the present invention. Similar to high aspect ratio grid line 219A (described above), grid line 219B includes a high aspect ratio central metal structure 219B-1 and transparent supports 219B-2 formed on each side of central metal structure 219B-1. However, grid line 219B also includes one or more elongated contact metal layers 218B-1 and 218B-2 that are co-extruded simultaneously with and are located below central metal structure 219B-1 and transparent supports 219B-2. As described above, contact metal layers 218B-1 and 218B-2 include, for example a silicide-forming metal (or, after treatment, the silicide formed from such a metal).

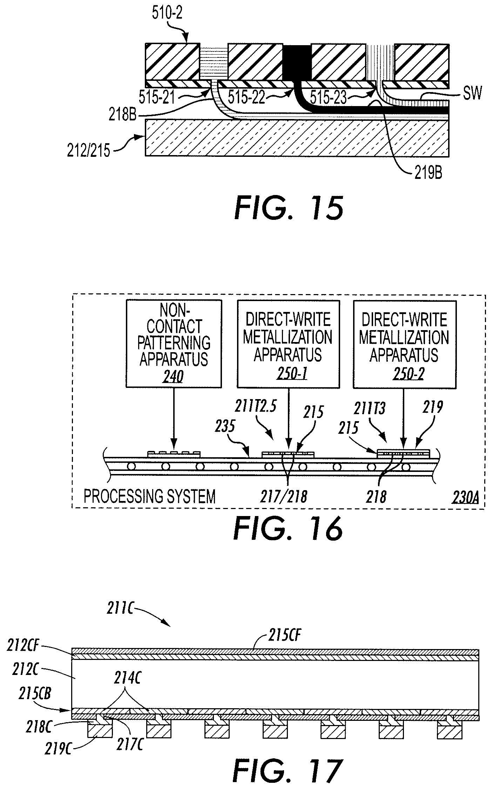

Fig. 15 is a cross-section showing a second nozzle 515-2 and a second grid line including a multi-layer stack formed by a contact forming metal portion 218B, a conductive metal portion 219B, and a solder wetting material SW. These materials are respectively extruded through openings 515-21, 515-22, and 515-23 in the manner depicted in Fig. 15. Any of these layers may serve a dual function, for example, copper is both highly conductive and can readily be soldered. As with other co-extruded structures, the complete extrusion may optionally include a transparent or sacrificial structure to the side or sides of the gridline to support its high-aspect ratio metal portion.

In accordance with another embodiment of the present invention, the contact material (i.e., the material disposed at the substrate-gridline interface) contains compounds that adhere to the silicon nitride (i.e., the preferred passivation material). In conventional silver pastes the glass frit promotes adhesion between the gridline and the substrate. In a preferred embodiment, the frit employed has the novel distinction from conventional pastes in that it is designed to not burn through the silicon nitride, but only to stick to the nitride in order to promote adhesion. It is also of sufficiently low density to permit silicide formation in the contact openings. In another preferred embodiment, the emitter doping of front surface contact cell-type photovoltaic devices formed in accordance with the present invention is such that the emitter sheet resistance is on the order of 100 Ohms/square or higher, and the surface concentration of the emitter dopant species is non-degenerate. The light emitter and surface doping improves the conversion efficiency and blue response of the solar cell.

In accordance with yet another embodiment, the multiple layer grid line structures described above (e.g., with reference to Fig. 15) are formed using two or more sequentially arranged direct-write metallization apparatus. For example, as indicated in Fig. 16, a processing system 230A includes a first direct-write metallization apparatus 250-1 located immediately downstream from non-contacting patterning apparatus 240, and a second direct-write metallization apparatus 250-2 located immediately downstream from first direct-write metallization apparatus 250-1. First direct-write metallization apparatus 250-1 may be, for example, an inkjet-type printing apparatus that is utilized to print contact portions 218 into openings 217 in the manner described above. Second direct-write metallization apparatus 250-2 may be, for example, an extrusion-type dispensing apparatus that is utilized to dispense conductive metal lines 219 over passivation layer 215 and contact portions 218. In this manner, two or more metallization devices may be ganged in sequence to apply the metallization. In a specific embodiment, dissimilar metals (e.g., Ni and Cu, or Ni and Ag) are sequentially printed using, e.g., two inkjet-type printers to provide a silicide forming material into each contact opening, and then to provide a layer of dissimilar metal printed over the silicide forming material and the passivation layer to form a continuous line or area joining associated contacts.

Although the present invention is described above with specific reference to the production of front surface contact cell-type photovoltaic devices, the methods described herein may also be used to produce backside contact cell-type photovoltaic devices in a highly efficient manner. In particular, the overall fabrication costs required to produce backside contact cell-type photovoltaic devices in accordance with the teachings of US Published Application No. US20040200520A1 may be substantially reduced by utilizing the laser patterning and direct-write metallization procedures described herein.

Fig. 17 is a cross-sectional side view showing a backside contact cell-type photovoltaic device 211C formed in accordance with another embodiment of the present invention. Backside contact device 211C generally includes an N-type silicon wafer (substrate) 212C disposed between a lightly doped upper (front) diffusion 212CF and an array of interspersed N-type and P-type diffusion regions 214C, which are formed in a lower (backside) surface of wafer 212C. A textured front passivation layer 215CF is formed over upper diffusion 212CF. A backside passivation layer 215CB is formed below diffusion regions 214C, which is patterned to provide openings 217C using the methods described above. Backside contact portions 218C are extend through openings 217C and contact diffusion regions 214C in the manner described above, and conductive metal layer 219C is formed on contact portions 218C. The operating principles of backside contact cell-type photovoltaic device 211C are essentially identical to conventional backside contact cells and are known to those skilled in the art. In accordance with an exemplary embodiment, backside contact openings are formed in accordance with the production data summarized in Table 2 (below). This system writes 30 micron holes on a spacing of 280 microns onto a 12.5 cm wafer in a time of two seconds/wafer. In order to place spots onto the wafer with 30 micron accuracy, the timing stability of the laser needs to be on the order of one microsecond.

**Table 2**

| **Back Contact Cell Design** | | | | |
|---|---|---|---|---|
| Pulse Width | 25 nsec | or less | Pulse Power | 90 microJoule |
| Power Density | 10 J/cm2 | | Number of scans | 446 /wafer |
| Spot Size | 30 microns | | Shots | 199298 /wafer |
| Wafer Time | 2 sec | | Repetition Rate | 0.0996 MHz |
| Wafer Size | 125 mm | | Timing stability | 1.0752E-06 sec |
| Hole spacing | 280 microns | | Laser Power | 8.968431122 Watts |
| Possible Laser Source: | Coherent AVIA 266-300 | 300 | Scan Speed | 27901.78571 mm/sec |
| Wavelength 266 nm | | | | |

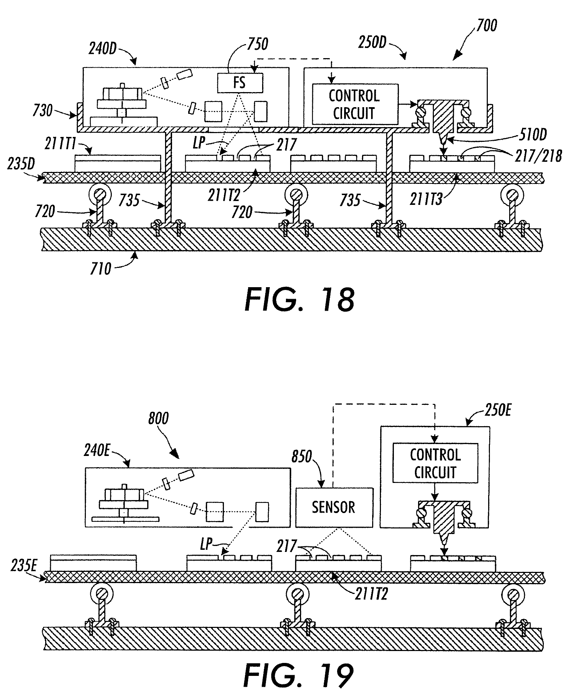

Referring to Fig. 18, in accordance with an embodiment of the present invention, the precise placement of metallization over the contact openings without an expensive and time consuming alignment step is achieved by providing in-line processing tool 700 in which a conveyor 235D, a non-contact patterning apparatus 240D, and a direct-write metallization apparatus 250D are maintained in a hard tooled fixed registration. In the depicted example, the hard tooled fixed registration is achieved by fixedly connecting each of the components to a fixed base 710. For example, conveyor 235D is supported by rollers that are fixedly connected to base 710 by way of supports 710, and non-contact patterning apparatus 240D and direct-write metallization apparatus 250D are fixedly attached to a frame 730, which in turn is fixedly attached to base 710 by way of supports 735. In addition, devices 211 are secured to conveyor 235D such that devices 211 retain a hard tooled fixed feature registration when passing between non-contact patterning apparatus 240D and direct-write metallization apparatus 250D. That is, by providing conveyor with a securing mechanism (e.g., vacuum suction or a mechanical fixture) that maintains each device 211 in a fixed registration relative to non-contact patterning apparatus 240 and direct-write metallization apparatus 250, then the patterning and metallization processes can be performed without requiring adjustment or alignment before metallization is performed. Proper alignment within the processing system 700 of non-contact patterning apparatus 240D and direct-write metallization apparatus 250D relative to base 710 is typically sufficient to ensure prolonged alignment of the contact openings and deposited materials on devices 211. The precision of alignment of the contact openings and the subsequent metallization can be less than 25 microns.

In accordance with another embodiment, the laser scanning process utilized by non-contact patterning device 240D can be timed in such a way that the hard tooled registration of contact openings 217 and the subsequent deposition of contact portions 218 are achieved electronically. For example, a feedback system 750 incorporated into non-contact patterning device 240D may be utilized to determine the start of each laser scan, and the firing of laser pulses LP is timed in such a way that contact openings 217 fall in regions where the metallization elements will subsequently deposit metal. The feedback system 750 may sense the optical pulses generated by the laser, or may optionally sense an additional laser beam injected colinearly with the optics. Such additional laser beam may operate as a continuous wave device and thereby serve as a beam spot location reference even when the ablation source is not firing. This provides the flexibility of using inkjet-type printing apparatus and/or paste dispensing nozzles with relatively imprecise print element placement. Registration is maintained through a one-time calibration.

In accordance with a specific embodiment, electronic registration of the contact openings with the metallization can be achieved using the characteristics of a femto-second laser. Typically, these lasers provide ablative pulses at a much faster repetition rate than is required to place the contact openings at their optimal 0.1mm to 1.5mm pitch distance. The repetition rates for these pulses can be 80 MHz, perhaps a thousand times faster than the slower rate required to place the contact openings. The slower firing rate can be achieved by counting the pulses, and only allowing the pulses to ablate the passivation layer after counting a plurality of pulses, for instance 1000 pulses. An acusto-optic modulator may be used to select the particular pulse used for ablation, refracting unused pulses out of the ablation light path. Therefore, it is an aspect of this invention that this count be adjusted dynamically. The count could be set to 990 or 1005, for instance, therefore adjusting in small increments the location in the fast direction where the laser ablates the passivation. This dynamic adjustment can be used for several purposes: The first can be to remove inherent non-linearities in the scan lens or scanning instrument, where the scan velocity may vary from a constant velocity by enough to cause the passivation openings to fall outside the region that would place them directly under the linear metallization grid. By measuring the actual velocity variation in a scan beforehand and storing the information, the velocity variation information could be used to compute the correction counts applied during a scan time to place the openings co-incident with the metallization grid. The scan would be broken into several regions, each region having an average velocity. The correction algorithm would use the piecewise linear velocity information to compute a count that would direct a pulse of laser light to create an opening when the laser is predicted to be co-incident with the metalization grid.

The second purpose is to adjust the high energy pulse firing positions to account for a polygon rotation velocity that may vary. A large enough variation in polygon speed over hundreds of scans could place the opening position outside the region required to be co-incident with the metallization grid. By dynamically measuring the true polygon scan or rotation rate during scanning, the adjustment counts could be computed and applied to stabilize the variation and accurately place the opening directly under the metallization grid.

Finally, these correction counts delivered to the acusto-optic modulator to deliver a pulse to the ablation layer could be computed simultaneously using speed variation information from both velocity variations, therefore together dynamically adjusting the passivation ablation opening position in the fast direction to compensate for polygon rotation rate variation and for laser scan velocity variation.

Although hard tooled registration is presently preferred, it is recognized that certain aspects of the present invention may be utilized in processing tools that do not utilize hard tooled registration. For example, Fig. 19 shows an in-line processing tool 800 in which a non-contact patterning apparatus 240E and a direct-write metallization apparatus 250E are supported over a conveyor 235E, but not necessarily in the hard tooled registration described above. In this case, one or more sensors 850 are utilized to identify either features printed on or otherwise fixed on devices 211, or to identify the placement of openings 217, e.g., between patterning and metallization. The information generated by sensor 850 is then forwarded to direct-write metallization apparatus 250E, which adjusts the printing/deposition process in accordance with the detected positions of contact openings 217.

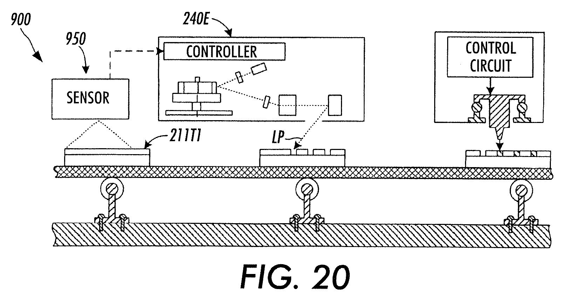

Fig. 20 shows an in-line processing tool 900 in which a non-contact patterning apparatus 240E is subjected to alignment and registration to existing features on device 211T1 - for example, the p and n doped stripes on the back of a backside contact-type device (described above). In this case, a sensor 950 precedes the non-contact patterning apparatus 240E, and transmits the alignment/registration information to a controller of non-contact patterning apparatus 240E.

Although the present invention has been described with respect to certain specific embodiments, it will be clear to those skilled in the art that the inventive features of the present invention are applicable to other embodiments as well, all of which are intended to fall within the scope of the present invention. For example, although the description above is primarily limited to silicon-based photovoltaic devices, the various aspects of the present invention may also be utilized in the production of photovoltaic devices on wafers formed by amorphous silicon, CdTe, or CIGS (copper-indium-gallium-diselenide).

## Claims

1. A method for producing a photovoltaic device, the photovoltaic device including a semiconductor wafer (212), one or more doped regions (214) formed in a surface (213) of the semiconductor wafer, and a plurality of conductive lines (219) disposed over the surface (213) of the semiconductor wafer and contacting said one or more doped regions (214), the method comprising:
forming (110) a blanket passivation layer (210, 215) on the surface of the semiconductor wafer;
utilizing (120) a non-contact patterning apparatus (240) to define a plurality of openings (217) through the blanket passivation layer, whereby each said opening exposes a corresponding one of said one or more doped regions (214) on the surface of the semiconductor wafer; and
utilizing (130) a direct-write metallization apparatus to deposit a contact portion (218) of said conductive lines (219) into each of the plurality of openings,
**characterized in that**
the direct-write metallization apparatus (240) is an inkjet-type printing apparatus or an extrusion-type deposition apparatus.

2. The method according to Claim 1, wherein utilizing the non-contact patterning apparatus (240) comprises controlling a laser to generate a plurality of high energy laser pulses such that each said high energy laser pulse ablates said passivation layer to produce a corresponding one of said openings.

3. The method according to Claim 2, wherein controlling the laser comprises directing the laser beam onto a rotating mirror (330) such that the plurality of laser pulses are directed in a predetermined scan pattern on the blanket passivation layer (210, 215).

4. The method according to Claim 3,
wherein the photovoltaic device comprises a front surface contact cell including a plurality of parallel grid lines disposed over the surface of the semiconductor wafer, and
wherein controlling the laser comprises directing the laser beam such that the predetermined scan pattern defined by a main scanning direction of the rotating mirror (330) is parallel to the plurality of grid lines.

5. The method according to Claim 2, wherein controlling the laser comprises using information about the velocity that a laser spot generated by the laser is scanning on the passivation layer, and controlling a high energy laser to produce high energy ablation pulses that are co-incident with a predetermined scan position.

6. The method according to Claim 5, where the high energy laser comprises a femtosecond laser.

7. The method according to Claim 5, wherein using information about the velocity that the laser spot is scanning comprises one of information about the non-linear scan speed and information about the polygon rotation rate.

8. The method according to Claim 5, wherein producing high energy ablation pulses that are co-incident with a predetermined scan position produces pulses that are co-incident with a metallization grid.

9. A system (200) for producing a photovoltaic device, the photovoltaic device including a semiconductor wafer (212), one or more doped regions (214) formed in a surface (213) of the semiconductor wafer, and a plurality of conductive lines (219) disposed over the surface of the semiconductor wafer and contacting said one or more doped regions, the system comprising:
a non-contact patterning apparatus for defining a plurality of openings (217) through a blanket passivation layer (210, 215) formed on the semiconductor wafer, whereby each said opening (217) exposes a corresponding one of said one or more doped regions (214) on the surface of the semiconductor wafer;
a direct-write metallization apparatus (250) for depositing a contact portion (218) of said conductive lines into each of the plurality of openings; and
a conveyor mechanism (235) for supporting the wafer during processing by both the non-contact patterning apparatus and the direct-write metallization apparatus, and for conveying the wafer between the non-contact patterning apparatus and the direct-write metallization apparatus,
**characterized in that**
the direct-write metallization apparatus (240) is an inkjet-type printing apparatus or an extrusion-type deposition apparatus.

## Patentansprüche

1. Verfahren zur Herstellung einer Fotovoltaik-Einrichtung, wobei die Fotovoltaik-Einrichtung eine Halbleiterscheibe (212), ein oder mehrere dotierte Gebiete (214), die in einer Oberfläche (212) der Halbleiterscheibe ausgebildet sind, und mehrere Leitungen (219) aufweist, die über der Oberfläche (213) der Halbleiterscheibe angeordnet sind und einen Kontakt zu dem einen oder den mehreren dotierten Gebieten (214) herstellen, wobei das Verfahren umfasst:
Bilden (110) einer ganzflächigen Passivierungsschicht (210, 215) auf der Oberfläche der Halbleiterscheibe;
Verwenden (120) einer Vorrichtung zur kontaktlosen Strukturierung (240), um mehrere Öffnungen (217) durch die ganzflächige Passivierungsschicht hindurch zu bilden, wobei jede Öffnung ein entsprechendes Gebiet des einen oder der mehreren dotierten Gebiete (214) auf der Oberfläche der Halbleiterscheibe freilegt; und
Verwenden (130) einer Vorrichtung zur direkten Aufbringung einer Metallisierung, um einen Kontaktbereich (218) der Leitungen (219) in jeder der mehreren Öffnungen abzuscheiden,
**dadurch gekennzeichnet, dass**
die Vorrichtung zur direkten Aufbringung einer Metallisierung (240) eine Druckvorrichtung des Tintenstrahldruckertyps oder eine Abscheidevorrichtung des Extrusionstyps ist.

2. Verfahren nach Anspruch 1, wobei die Verwendung der kontaktfreien Strukturierungsvorrichtung (240) umfasst: Steuern eines Lasers, um mehrere Hochenergie-Laser-Pulse derart zu erzeugen, dass jeder Hochenergie-Laser-Puls die Passivierungsschicht abträgt, um eine entsprechende Öffnung der Öffnungen zu erzeugen.

3. Verfahren nach Anspruch 2, wobei Steuern des Lasers umfasst: Lenken des Laserstrahls auf einen rotierenden Spiegel (330) derart, dass die mehreren Laser-Pulse in einem vorbestimmten Abtastmuster auf die ganzflächige Passivierungsschicht (210, 215) gelenkt werden.

4. Verfahren nach Anspruch 3,
wobei die Fotovoltaik-Einrichtung eine Vorderflächen-Kontaktstelle mit mehreren parallelen Gitterlinien, die über der Oberfläche der Halbleiterscheibe angeordnet sind, aufweist, und
wobei Steuern des Lasers umfasst: Lenken des Laserstrahls derart, dass das vorbestimmte Abtastmuster, das durch eine Hauptabtastrichtung des rotierenden Spiegels (330) festgelegt ist, parallel zu den mehreren Gitterlinien liegt.

5. Verfahren nach Anspruch 2, wobei Steuern des Lasers umfasst: Verwenden von Information über die Geschwindigkeit, mit der ein von dem Laser erzeugte Laser-Fleck auf der Passivierungsschicht abtastend bewegt wird, und Steuern eines Hoch-energie-Lasers derart, dass Hochenergie-Abtragungspulse erzeugt werden, die mit einer vorbestimmten Abtastposition übereinstimmen.

6. Verfahren nach Anspruch 5, wobei der Hochenergie-Laser einen Femto-Sekunden-Laser umfasst.

7. Verfahren nach Anspruch 5, wobei Verwenden von Information über die Geschwindigkeit, mit der der Laser-Fleck abtastend bewegt wird, eine Information über die nicht-lineare Abtastgeschwindigkeit und eine Information über die Polygon-Drehgeschwindigkeit umfasst.

8. Verfahren nach Anspruch 5, wobei das Erzeugen von Hochenergie-Abtragungspulsen, die mit einer vorbestimmten Abtastposition übereinstimmen, Pulse erzeugt, die mit einem Metallisierungsgitter übereinstimmen.

9. System (200) zur Herstellung einer Fotovoltaik-Einrichtung, wobei die Fotovoltaik-Einrichtung eine Halbleiterscheibe (212), ein oder mehrere dotierte Gebiete (214), die in einer Oberfläche (213) der Halbleiterscheibe ausgebildet sind, und mehrere Leitungen (219), die über der Oberfläche der Halbleiterscheibe ausgebildet sind und einen Kontakt zu dem einen oder den mehreren dotierten Gebieten herstellen, aufweist, wobei das System umfasst:
eine Vorrichtung zur kontaktlosen Strukturierung zur Bildung mehrere Öffnungen (217) durch eine ganzflächige Passivierungsschicht (210, 215), die auf der Halbleiterscheibe ausgebildet ist, wodurch jede Öffnung (217) ein entsprechendes Gebiet des einen oder der mehreren dotierten Gebiete (214) auf der Oberfläche der Halbleiterscheibe freilegt;
eine Vorrichtung zur Direktaufbringung einer Metallisierung zum Abscheiden eines Kontaktbereichs (218) der Leitungen in jeder der mehreren Öffnungen; und
einen Transportmechanismus (235) zum Halten der Scheibe während der Verarbeitung sowohl durch die Vorrichtung zur kontaktlosen Strukturierung als auch die Vorrichtung zur direkten Aufbringung einer Metallisierung, und zum Transport der Scheibe zwischen der Vorrichtung zur kontaktlosen Strukturierung und der Vorrichtung zur direkten Aufbringung einer Metallisierung,
**dadurch gekennzeichnet, dass**
die Vorrichtung zur direkten Aufbringung einer Metallisierung (240) eine Druckvorrichtung des Tintenstrahldruckertyps oder eine Abscheidevorrichtung des Extrusionstyps ist.

## Revendications

1. Procédé pour produire un dispositif photovoltaïque, le dispositif photovoltaïque comprenant une plaquette semi-conductrice (212), une ou plusieurs régions dopées (214) formées dans une surface (213) de la plaquette semi-conductrice, et une pluralité de lignes conductrices (219) disposées sur la surface (213) de la plaquette semi-conductrice et en contact avec lesdites une ou plusieurs régions dopées (214), le procédé comprenant les étapes consistant à :
former (110) une couche de passivation de couverture (210, 215) sur la surface de la plaque semi-conductrice ;
utiliser (120) un appareil de dessin sans contact (240) afin de définir une pluralité d'ouvertures (217) à travers la couche de passivation de couverture, moyennant quoi chacune desdites ouvertures expose une région correspondante desdites une ou plusieurs régions dopées (214) sur la surface de la plaquette semi-conductrice ; et
utiliser (130) un appareil de métallisation à écriture directe pour déposer une partie de contact (218) desdites lignes conductrices (219) dans chacune de la pluralité d'ouvertures,
**caractérisé en ce que** :
l'appareil de métallisation à écriture directe (240) est un appareil d'impression de type à jet d'encre ou un appareil de dépôt de type à extrusion.

2. Procédé selon la revendication 1, dans lequel l'étape consistant à utiliser l'appareil de dessin sans contact (240) comprend l'étape consistant à contrôler un laser afin de générer une pluralité d'impulsions laser à haute énergie de sorte que chacune desdites impulsions laser à haute énergie ablate ladite couche de passivation afin de produire une ouverture correspondante desdites ouvertures.

3. Procédé selon la revendication 2, dans lequel l'étape consistant à contrôler le laser comprend l'étape consistant à diriger le faisceau laser sur un miroir rotatif (330) de sorte que la pluralité d'impulsions laser sont dirigées selon un motif de balayage prédéterminé sur la couche de passivation de couverture (210, 215).

4. Procédé selon la revendication 3,
dans lequel le dispositif photovoltaïque comprend une cellule de contact de surface avant comprenant une pluralité de lignes de quadrillage parallèles disposées sur la surface de la plaquette semi-conductrice, et
dans lequel l'étape consistant à contrôler le laser comprend l'étape consistant à diriger le faisceau laser de sorte que le motif de balayage prédéterminé défini par une direction de balayage principale du miroir rotatif (330) est parallèle à la pluralité de lignes de quadrillage.

5. Procédé selon la revendication 2, dans lequel l'étape consistant à contrôler le laser comprend l'étape consistant à utiliser l'information concernant la vitesse à laquelle un point laser généré par le laser balaie sur la couche de passivation et contrôler un laser à haute énergie afin de produire des impulsions d'ablation à haute énergie qui coïncident avec une position de balayage prédéterminée.

6. Procédé selon la revendication 5, dans lequel le laser à haute énergie comprend un laser femtoseconde.

7. Procédé selon la revendication 5, dans lequel l'utilisation de l'information concernant la vitesse à laquelle le point laser balaie comprend l'une parmi l'information concernant la vitesse de balayage non linéaire et l'information concernant la vitesse de rotation polygonale.

8. Procédé selon la revendication 5, dans lequel la production des impulsions d'ablation à haute énergie qui coïncident avec une position de balayage prédéterminée produit des impulsions qui coïncident avec une grille de métallisation.

9. Système (200) pour produire un dispositif photovoltaïque, le dispositif photovoltaïque comprenant une plaquette semi-conductrice (212), une ou plusieurs régions dopées (214) formées dans une surface (213) de la plaquette semi-conductrice, et une pluralité de lignes conductrices (219) disposées sur la surface de la plaquette semi-conductrice et en contact avec lesdites une ou plusieurs régions dopées, le système comprenant :
un appareil de dessin sans contact pour définir une pluralité d'ouvertures (217) à travers une couche de passivation de couverture (210, 215) formée sur la plaquette semi-conductrice, moyennant quoi chacune desdites ouvertures (217) expose une région correspondante desdites une ou plusieurs régions dopées (214) sur la surface de la plaquette semi-conductrice ;
un appareil de métallisation à écriture directe (250) pour déposer une partie de contact (218) desdites lignes conductrices dans chacune de la pluralité d'ouvertures ; et
un mécanisme de transporteur (235) pour supporter la plaquette pendant le traitement à la fois par l'appareil de dessin sans contact et l'appareil de métallisation à écriture directe, et pour transporter la plaquette entre l'appareil de dessin sans contact et l'appareil de métallisation à écriture directe,
**caractérisé en ce que**
l'appareil de métallisation à écriture directe (240) est un appareil d'impression de type à jet d'encre ou un appareil de dépôt de type à extrusion.
